(19) Europäisches Patentamt
European Patent Office
Office européen des brevets

(11) Veröffentlichungsnummer: **0 174 003**
**B1**

(12) **EUROPÄISCHE PATENTSCHRIFT**

(45) Veröffentlichungstag der Patentschrift: **08.08.90**

(51) Int. Cl.$^5$: **C 30 B 15/30,** C 30 B 13/32

(21) Anmeldenummer: **85111100.5**

(22) Anmeldetag: **03.09.85**

# (54) Stab- und Tiegel-Halterung.

(30) Priorität: **04.09.84 DE 3432467**

(43) Veröffentlichungstag der Anmeldung:
**12.03.86 Patentblatt 86/11**

(45) Bekanntmachung des Hinweises auf die Patenterteilung:
**08.08.90 Patentblatt 90/32**

(84) Benannte Vertragsstaaten:
**AT BE CH DE FR GB IT LI LU NL SE**

(56) Entgegenhaltungen:
**DE-A-1 519 838**
**DE-A-2 306 755**
**FR-A-1 340 477**

**IBM TECHNICAL DISCLOSURE BULLETIN, Band 26, Nr. 10B, März 1984, Seiten 5542-5543, IBM CORP., New York, US; K.M. KIM et al.: "Elimination of crystal orbiting in czochralski cable puller with a coaxial magnet and magnetic weight"**

(73) Patentinhaber: **Forschungszentrum Jülich GmbH**
**Postfach 1913**
**D-5170 Jülich (DE)**

(72) Erfinder: **Boden, Karl**
**Siemenstrasse 20**
**D-5170 Jülich (DE)**
Erfinder: **Ibach, Harald, Prof., Dr.**
**Kalkbergstrasse 167**
**D-5100 Aachen-Verlautenheide (DE)**
Erfinder: **Linke, Udo**
**Im Reuter 37**
**D-5160 Düren (DE)**

(56) Entgegenhaltungen:

**PATENT ABSTRACTS OF JAPAN, Band 8, Nr. 172 (C-237)1609r, 9. August 1984; & JP-A-59 69 491 (GAKEI DENKI SEISAKUSHO K.K.) 19-04-1984**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

**Beschreibung**

Die Erfindung bezieht sich auf eine Stab- und Tiegel-Halterung für Vorrichtungen zum tiegellosen Zonenschmelzen und zum Ziehen aus dem Tiegel mit einem, an der Halterung angebrachten magnetisierbaren Kern, der mittels eines Magneten (Axialstabilisierungsmagnet) aufgehängt ist, an dem eine Einrichtung zur axialen Verschiebung angreift.

Eine Halterung der vorgenannten Art ist, soweit sie das tiegellose Zonenschmelzverfahren betrifft, aus der DE—PS—23 06 755 bekannt. Die zum Transport der Schmelze längs der Zuchtachse notwendige axiale Verschiebung wird hierbei durch einen außerhalb der Zonenschmelzkammer angeordneten Mitnehmerelektromagneten bewirkt. Bei der axialen Verschiebung des ferromagnetischen Kerns gleitet dieser jedoch entlang der Schmelzkammerwandung, so daß Erschütterungen und unerwünschte Schwingungen, die sich auf das spontane Kristallwachstum störend auswirken, nicht zu vermeiden sind. Auch kann nicht verhindert werden, daß über den an der Wandung der Schmelzkammer anliegenden ferromagnetischen Kern von außen Erschütterungen, die beispielsweise beim Bewegen des Mitnehmerelektromagneten auftreten, sowie sonstige Stöße von außen auf den kristallinen Körper übertragen werden.

Es ist Aufgabe der Erfindung, eine Halterung der eingangs bezeichneten Art zu schaffen, bei der der kristalline Körper und/oder der Schmelztiegel—so beim Tiegelschmelzverfahren nach Czochralski—oder—im Falle der Durchführung des tiegellosen Zonenschmelzverfahrens—der Vorratsstab derart gehalten wird und in axialer Weise verschiebbar ist, daß dabei keine von außen kommenden oder bei der Verschiebung erzeugten Erschütterungen oder sonstige Stöße auf den kristallinen Körper übertragen werden.

Diese Aufgabe wird gemäß der Erfindung dadurch gelöst, daß wenigstens eine Radialstabilisierungseinrichtung für den magnetisierbaren Kern vorgesehen ist, die aus den magnetisierbaren Kern berührungslos umschließenden Elektromagneten, einem elektronischen Regelgerät und Positionssensoren besteht, wobei die Elektromagnete vom elektronischen Regelgerät mit Signalen beaufschlagt werden, die von diesem als Funktion der Signale der Positionssensoren, welche auf die Abweichungen des magnetisierbaren Kerns von seiner Sollage ansprechen, erzeugt werden. Durch die berührungslose Fixierung des magnetisierbaren Kerns in der axialen Lage wird—abgesehen von der reibungslosen axialen Verschiebung—erreicht, daß der magnetisierbare Kern und der an der Halterung befestigte kristalline Körper und/oder der Tiegel oder der Vorratsstabteil frei von Erschütterungen und Schwingungen bleibt.

Da die Radialstabilisierungseinrichtung bewirkt, daß der magnetisierbare Kern auch bei einer axialen Verschiebung in der radialen Sollage bleibt, wird er somit durch die Magnetkräfte in axialer Richtung geführt. Einer weiteren Führung des magnetisierbaren Kerns, wie dies beispielsweise bei der aus der DE—PS—23 06 755 bekannten Vorrichtung durch die Behälterinnenwand im Bereich des ferromagnetischen Kerns geschieht, bedarf es daher bei der Halterung gemäß der Erfindung nicht, ebensowenig, wie es eines den kristallinen Körper einschließenden Behälters bedarf. Die Halterung gemäß der Erfindung ist daher bei Kristallzuchtapparaturen sowohl mit als auch ohne einen den kristallinen Körper einschließenden Behälter einsetzbar.

Für den Fall, daß ein den sich bildenden kristallinen Körper einschließender Behälter oder eine Kammer (beispielsweise eine hochdichte Druckkammer) vorgesehen ist, muß die Wandung des Behälters oder der Kammer allerdings in dem den magnetisierbaren Kern umfassenden Bereich aus nichtmagnetisierbarem Material bestehen. Gleitende Dichtungen und sonstige Dichtungen im Bereich der Behälterwandung, wie sie insbesondere bei einer mechanischen radialen Führung bzw. einer mechanischen Einrichtung zur axialen Verschiebung der Halterung notwendig wären, entfallen. Die Halterung gemäß der Erfindung eignet sich daher in besonderem Maße für Zuchtprozesse, bei denen die in der kammer befindliche Atmosphäre höchsten Reinheitsansprüchen genügen muß.

Eine vorteilhafte Ausführungsform der Halterung gemäß der Erfindung besteht, besonders im Hinblick auf eine Vorrichtung mit Behälter oder Kammer, darin, daß die Radialstabilisierungseinrichtung ringförmig ausgebildet ist und den magnetisierbaren Kern, zwischen diesem und sich einen Ringspalt bildend, umschließt. Dabei kann zweckmäßig sein, daß die Elektromagnete der Radialstabilisierungseinrichtung mit einer im Ringspalt im wesentlichen radial gerichteten Vormagnetisierung versehen sind. Zur Vormagnetisierung können dabei Permanentmagnete vorgesehen sein.

Bei der zuletzt genannten Ausführungsform der Halterung ist ohne weiteres ein Ringspalt mit einer Spaltbreite von mehr als 13 mm realisierbar, so daß der Zuchtraum für den kristallinen Körper auch durch einen dickwandigen Hochdruckkessel abgekapselt werden kann. Es bleibt dabei im zylindrischen Spalt genügend Raum für zusätzliche Temperierelemente, beispielsweise zum Heizen der Kesselwand oder auch zum Kühlen der Elemente der Radialstabilisierungseinrichtung und des Magneten, sowie für eine korrosionsfeste Auskleidung der Kesselwand und der Halterungen. Derartige Maßnahmen sind beispielsweise bei der Zucht von Einkristallen aus den sog. III—V-Verbindungen erforderlich, wovon besonders GaAs, InP und GaP hervorzuheben sind. Diese Kristallgruppen enthalten flüchtige Bestandteile, die dazu neigen, aus der Schmelze heraus zu verdampfen. Folglich reichern sich diese Bestandteile im Gasraum der Zuchtkammer an bei gleichzeitiger Abmagerung in der Schmelze. Der Abmagerungsprozeß kann vermindert werden durch Aufrechterhalten eines Kammerdruckes, der oberhalb des Gleichgewichts- bzw. Dissoziationsdruckes in der Schmelze liegen muß. Dieser Druck beträgt zwar z.B. bei einer Schmelztemperatur von 1239°C des Galliumarsenid für das flüchtige Arsen lediglich 0.89 at ($0.9\times10^5$ Pa), liegt jedoch bei einer Schmelztemperatur von 1070°C des Indiumphosphit für den Phosphor bei 60 at ($60,8\times10^5$ Pa). Um darüber hinaus eine Sublimation oder Kondensation der leicht flüchtigen Bestandteile zu umgehen, müssen alle den Zuchtraum begrenzenden Flächen auf einer Temperatur oberhalb des Sublimations- bzw. Kondensationspunktes gehalten werden. Das geschieht durch Aufheizen der Kammerwandung, wobei die innere Kammeroberfläche und die Halterungen mit Quarzglas oder Graphit ausgekleidet sein können, wodurch korrosive Einflüsse der bei hohen Temperaturen sehr reaktionsfähigen Arsen- und Phosphordämpfe vermieden werden.

Bei einer weiteren Ausführungsform der Halterung gemäß der Erfindung ist der Axialstabilisierungsmagnet so angeordnet, daß er sich unmittelbar oberhalb der Elektromagnete der Stabilisierungseinrichtung befindet, so daß sein Magnetfeld den Ringspalt zwischen Elektromagneten und magnetisierbarem Kern im wesentlichen radial durchsetzt und die Vormagnetisierung bewirkt.

Die zur Verschiebung in axialer Richtung erforderliche Bewegung des Axialstabilisierungsmagneten kann dadurch erzeugt werden, daß der Axialstabilisierungsmagnet an einem Befestigungsrahmen—der Einrichtung zur Aufhängung der Halterung und deren axialen Verschiebung—angebracht ist, der separat in axialer Richtung verschiebbar ist. Bei einer besonders eleganten Ausführungsform der Halterung gemäß der Erfindung besteht die Einrichtung zur axialen Verschiebung des magnetisierbaren Kerns dagegen aus einem elektromagnetischen Linearmotor, der aus einem hohlzylindrischen Stator und dem magnetisierbaren Kern als Antriebselement besteht. Die axiale Verschiebung erfolgt dabei allein über magnetische Feldkräfte. Mechanisch bewegbare Teile sind dabei nicht vorgesehen.

Eine weitere zweckmäßige Ausführungsform besteht ferner darin, daß ein ringförmiger Drehfeldstator mit einem zwischen sich und dem magnetisierbaren Kern gebildeten Ringspalt vorgesehen ist. Der axialen Verschiebung des magnetisierbaren Kerns kann so mittels des Drehfeldstators eine Drehbewegung überlagert werden, falls diese aus qualitativen Gründen bei der Herstellung des kristallinen Körpers erwünscht ist.

Eine weitere, sehr vorteilhafte Ausführungsform der Halterung gemäß der Erfindung, bei der eine Kraftmeßeinrichtung vorgesehen ist, ermöglicht erstmals eine störungsfreie und genaue Bestimmung der Gewichtsänderung des kristallinen Körpers. Aufgrund der berührungslosen Lagerung der am Zuchtvorgang beteiligten Transportelemente werden die auf diese einwirkenden Kräfte, wie z.B. die Kristallgewichtsänderung, ohne verzerrende Reibungseffekte auf die Statoren und deren Befestigungsrahmen übertragen. Eine zwischen den das Gewicht des Zuchtelementes aufnehmenden Statorelementen und Rahmen angeordnete Kraftmeßeinrichtung mißt folglich diese Gewichtsänderung. Sie unterliegt, wenn sie im Außenraum der Zuchtapparatur angebracht ist, ferner keiner Beeinträchtigung durch Korrosion, Druck und Zuchtraumtemperatur oder Schleifringe, so daß die Gewichtsänderung ohne entsprechende Störpegel, Signaldrift und überlagerte Reibungskräfte mit höchster Genauigkeit und Stabilität ermittelt werden kann.

Der Aufbau dieser Meßeinrichtung ist vergleichsweise einfach und billig. Es entfallen gegenüber den bekannten Verfahren Schleifringe, Kesseldurchführungen, Abschirmungen, zusätzliche Kühleinrichtung sowie Maßnahmen zum Korrosionsschutz der Meßeinrichtung sowie zur Kompensation der Meßwertstörungen. Dabei kann die Kraftmeßeinrichtung direkt unterhalb des Axialstabilisierungsmagneten oder des Linearmotors, aber auch unterhalb des gesamten, beispielsweise den Linearmotor und die Elektromagnete der Radialstabilisierungseinrichtung umfassenden hohlzylindrischen Stators angeordnet sein.

Eine genaue Messung der Gewichtsänderung des kristallinen Körpers ist insbesondere für das Tiegelschmelzverfahren nach Czochralski von Bedeutung:

Aus Gründen der Wirtschaftlichkeit und der Kristallqualität wird über die nutzbaren Kristallängen des entstehenden kristallinen Körpers ein konstanter Durchmesser angestrebt. Die Einflußgrößen, von denen der Durchmesser des wachsenden kristallinen Körpers im wesentlichen abhängt, nämlich Schmelztemperatur und Geschwindigkeit der axialen Verschiebung des Kristalls, müssen dabei während der bis zu Tagen dauernden Kristallherstellung ständig kontrolliert werden. Eine der Möglichkeiten für eine automatische Regelung des Durchmesserverlaufs besteht dabei darin, daß die Gewichtsänderung des wachsenden Kristalls bzw. der Schmelze als Regelgröße benutzt wird. Dabei wird die Istgewichtsänderung ermittelt, diese mit einer Sollegewichtsänderung verglichen und die Differenz zum automatischen Verstellen der Heizleistung bzw. der Geschwindigkeit der axialen Verschiebung herangezogen. Da die zu messenden Gewichtsänderungen sehr klein und die dabei auftretenden Kräfte in der Größenordnung der bei bekannten Vorrichtungen bei der Axialverschiebung auftretenden Reibungskräfte sind, ist bisher eine fehlerfreie Messung der Gewichtsänderung mittels einer Kraftmeßeinrichtung nicht gelungen. Denn auch in den Fällen, in denen man die Kraftmeßeinrichtung innerhalb der Zuchtkammer angeordnet hat, ist sie störenden thermischen oder auch korrosiven Einflüssen ausgesetzt, die eine erhebliche Signaldrift verursachen. Ferner entfallen die Schleifringe, die bei während der Zucht rotierenden Kristallen sonst notwendig sind. Desgleichen entfallen elektrische und mechanische Durchführungen, die vielfach zu Lecks führen.

Eine radiale Verschiebung der Achse des kristallinen Körpers (bzw. des magnetisierbaren Kerns) kann dadurch erreicht werden, daß die außenliegenden elektromagnetischen Elemente der Radialstabilisierungseinrichtung mechanisch radial verlagert werden.

Ausführungsbeispiele der Halterung gemäß der Erfindung sind in der Zeichnung im Querschnitt wiedergegeben und werden im folgenden näher erläutert:

Es zeigen:

Figur 1 eine einfache Ausführungsform der Halterung für eine Vorrichtung zur Durchführung des Tiegelschmelzverfahrens mit magnetisch aufgehängtem und in axialer Richtung verschiebbarem Kristall,

Figur 2 eine einfache Ausführungsform der Halterung für eine Vorrichtung zur Durchführung des Tiegelschmelzverfahrens mit magnetisch aufgehängtem und in axialer Richtung verschiebbarem Schmelztiegel,

Figur 3 eine Ausführungsform der Halterung für eine Vorrichtung zur Durchführung des Tiegelschmelzverfahrens mit Zuchtkammer, Linearmotor zur axialen Fixierung und Verschiebung der Halterung des Kristalls sowie mit einer Kraftmeßeinrichtung zur Messung der Gewichtsänderung des Kristalls,

Figur 4 eine weitere Ausführung der Halterung

Figur 5 eine Ausführungsform der Halterung für eine Vorrichtung zur Durchführung des Zonenschmelzverfahrens.

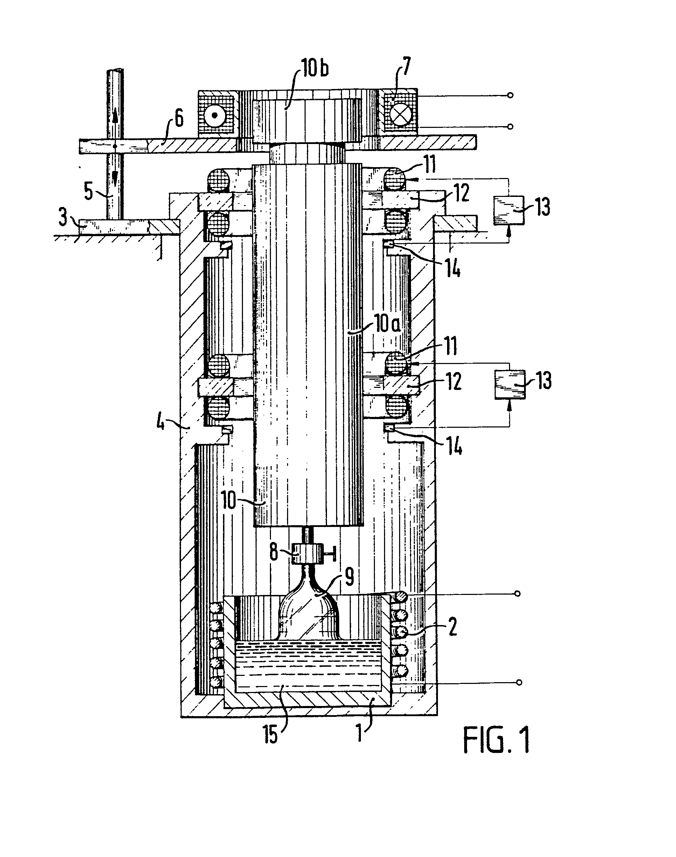

Die in Figur 1 dargestellte Vorrichtung weist einen Schmelztiegel 1 mit einer Widerstandsheizung 2 für den Schmelztiegel auf. Der Schmelztiegel steht auf dem mit der festen Unterlage 3 verbundenen Befestigungsrahmen 4 für die Radialstabilisierungseinrichtungen. Auch der Befestigungsrahmen 5 mit der in der Höhe verstellbaren Halteplatte 6 für den Elektromagneten 7 ist an der festen Unterlage 3 angebracht. Die Vorrichtung weist ferner eine Befestigung 8 für den Kristall 9 auf, an der der magnetisierbare Kern 10 befestigt ist. Dieser besteht in seinem unteren Teil aus einem langgestreckten Hohlzylinder 10a aus nichtrostendem, magnetisierbarem Stahl und einem darüber angeordneten zylindrischen Permanentmagneten 10b. Der Elektromagnet 7 ist in einer solchen Höhe angeordnet, daß er den Permanentmagneten 10b des magnetisierbaren Kerns in Arbeitsstellung umfaßt, so daß dieser—bei angeschaltetem Elektromagnet—in axialer Richtung fixiert wird. Die Höhenverschiebung der Halteplatte 6 kann mittels eines in der Zeichnung nicht dargestellten Spindelantriebs oder eines hydraulischen Zylinders erfolgen. Die zwei am Gestellrahmen 4 befestigten Radialstabilisierungseinrichtungen bestehen aus je vier Spulen 11 mit ferromagnetischem Kern 12, die jeweils paarweise einander gegenüberliegen und von denen nur die beiden in der Zeichnungsebene liegenden dargestellt sind und die jeweils paarweise mit elektronischen Regelgeräten 13 in elektrischer Verbindung stehen und von diesen mit einem Gleichstrom beaufschlagt werden, dessen Höhe von den Meßsignalen abhängig ist, die von induktiven Sensoren 14 ausgehen und den Regelgeräten 13 zugeleitet werden. Dabei werden die von den induktiven Sensoren an die Regelgeräte 13 geleiteten Meßsignale verstärkt und in ihrer Phase verschoben als Ausgangssignale in Form eines geregelten Gleichstromes an die Spulen 11 abgegeben.

Bei der Herstellung des Kristalls 9 wird dieser aus der Schmelze 15 gezogen. Hierzu wird der eingeschaltete Elektromagnet 7, an dem der magnetisierbare Kern 10 mit Befestigung 8 und dem daran befestigten Kristall 9 aufgehängt ist, in axialer Richtung verschoben.

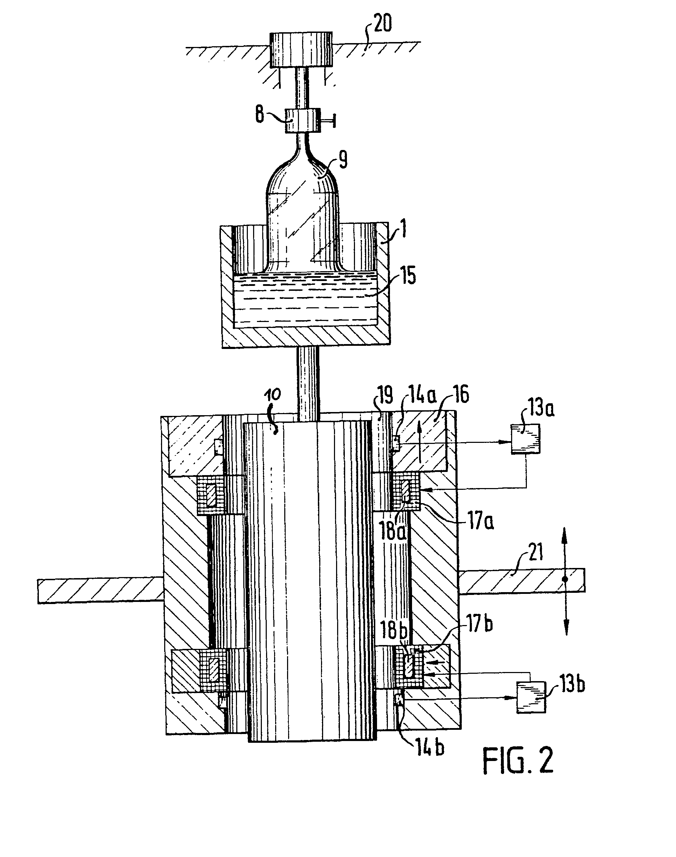

Bei der in Figur 2 dargestellten Vorrichtung ist—anders als bei der in Figur 1 dargestellten Vorrichtung—nicht der Kristall, sondern der Tiegel magnetisch aufgehängt. Hierzu ist unterhalb des Tiegels 1 der magnetisierbare Kern 10 angebracht, der in Arbeitsstellung an seinem oberen Ende von einem ringförmigen, als Axialstabilisierungsmagnet wirkenden Permanentmagneten 16 umfaßt wird. Unterhalb des Permanentmagneten befindet sich Ringspule 17a mit ferromagnetischem Kern 18a, die mit dem Regelgerät 13a und Feldplatten 14a in elektrischer Verbindung stehen. Der Permanentmagnet bewirkt eine radial gerichtete Vormagnetisierung im Ringspalt 19. Eine weitere Radialstabilisierungseinrichtung, bestehend aus Ringspule 17b, Kern 18b, Feldplatten 14b und Regelgerät 13b, befindet sich am unteren Ende des magnetisierbaren Kerns 10.

Die Ringspulen entsprechen im übrigen den in der DE—OS 24 20 814 gemachten Angaben.

Bei der in Figur 2 dargestellten Ausführungsform ist der Kristall über die Befestigung 8 unbeweglich an einem festen Rahmen 20 befestigt. Permanentmagnet 16 und die Ringspulen 17 sind an einem gemeinsamen, in der Höhe verstellbaren Gestellrahmen 21 befestigt. Der Tiegel 1 kann so bei der Herstellung des Kristalls in axialer Richtung verschoben werden.

Die Heizeinrichtung für den Tiegel ist in Figur 2 und den folgenden Figuren nicht dargestellt. Sie kann eine Widerstandsheizung oder beispielsweise auch eine HF-Spule sein.

Selbstverständlich können je nach Ausführungsform der Halterung sowohl Tiegel als auch Kristall magnetisch aufgehängt sein.

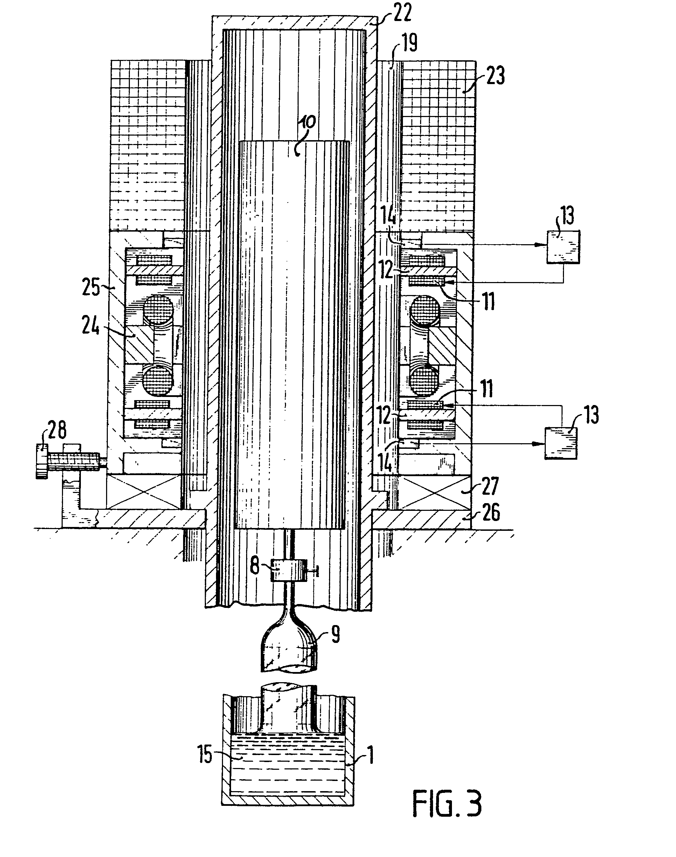

Bei der in Figur 3 dargestellten Vorrichtung ist ein nach außen abgekapselter Zuchtraum vorgesehen, der durch den Behälter 22 gebildet wird. Dieser umschließt den magnetisierbaren Kern 10, der, um eine hohe Betriebstemperatur zu ermöglichen, aus einer Stahllegierung mit hoher Curietemperatur besteht, wogegen sich die ringförmig ausgebildeten elektromagnetischen Elemente der Radialstabilisierungseinrichtung außerhalb des Behälters befinden. Die Behälterwandung befindet sich im Bereich der Magnete im Ringspalt 19. Sie besteht zumindest in diesem Bereich aus nichtmagnetisierbarem Material, beispielsweise aus Quarzglas oder aus einer nichtmagnetisierbaren Stahllegierung.

Der ringförmig ausgebildete Linearmotor 23 umschließt den magnetisierbaren Kern 10 in Arbeitsstellung an dessen oberem Ende. Er ist mit den beiden Radialstabilisierungseinrichtungen, bestehend aus Spulen 11, ferromagnetischem Kern 12, Regelgerät 13 und induktiven Sensoren 14 und einem Drehfeldstator 24 mechanisch fest mit dem Lagerstator 25 verbunden. Am unteren Ende des Lagerstators 25 ist, direkt auf der Unterlage 26 aufliegend, eine Kraftmeßeinrichtung 27 angeordnet.

Der Linearmotor 23 dient der axialen Fixierung des magnetisierbaren Kerns 10 und zugleich zu dessen axialen Verschiebung, so daß die axiale Verschiebung allein über magnetische Kräfte erfolgt und mechanische Mittel, wie Spindel u.dgl., entfallen.

Der Linearmotor kann aus einem einfachen Tauchspulensystem bestehen, wobei die stabile axiale Höhenlage des magnetisierbaren Kerns 10 eine Funktion des Spulenstromes ist. Die Länge des magnetisierbaren Kerns 10 ist um die Hublänge über die axialen Statorabmessungen hinaus verlängert, so daß alle Arbeitsfunktionen über den gesamten Hubbereich gewährleistet sind.

Der Drehfeldstator 24 übt auf den magnetisierbaren Kern 10 ein Drehmoment aus, welches den Kern und damit den Kristall in Rotation um seine vertikale Achse versetzt. Die benötigte Antriebsleistung ist sehr gering, da Lager und Dichtreibung entfallen. Durch geeignete Materialauswahl und Formgebung des magnetisierbaren Kerns im Antriebsbereich können sowohl Synchronmotoren, wie z.B. Reluktanz- und Hysteresemotoren als auch Asynchronmotoren, wie Induktionsmotoren, in bekannter Weise angewendet werden. Hysteresemotoren erfordern lediglich zylindrische, ringförmige Rotorelemente aus magnetisierbarem Stahl. Aufgrund der geringen Antriebsleistung werden an die Hystereseeigenschaften dieser Stähle keine hohen Anforderungen gestellt, so daß sie aus dem Material des Kerns hergestellt werden können.

Der magnetisierbare Kern kann folglich als durchgehender Stahlzylinder gestaltet werden, der sowohl Lager- als Antriebsanforderungen genügt.

Auf der Kraftmeßeinrichtung 27 ruht das Gewicht des außerhalb der Schmelzkammer angeordneten Stators mit den daran befestigten Lager- und Antriebselementen sowie das Gewicht des magnetisch an den Stator gekoppelten Ziehgestänges, bestehend aus magnetisierbarem Kern 10, Befestigung 8 und dem Kristall 9. Eine Änderung des Kristallgewichts wirkt sich ohne den Einfluß störender Reibungskräfte als Änderung der auf die Kraftmeßeinrichtung einwirkenden Stützkraft aus. In einer bevorzugten Ausführung besteht diese Einrichtung aus drei, an den Spitzen eines gleichseitigen Dreiecks angeordneten Kraftmeßzellen. Durch gleichzeitige Addition der drei den Stützkraftanteilen proportionalen elektrischen Ausgangssignalen werden unsymmetrische und periodische, z.B. aus Taumelbewegungen und Unwuchten resultierende Störsignale eliminiert. Da alle anderen durch den Ziehprozeß bedingten thermischen, korrosiven und kammerdruckabhängigen Beeinflussungen der Meßergebnisse entfallen, mißt die Kraftmeßeinrichtung die zeitliche Änderung des Kristallgewichtes mit höchster Genauigkeit und Stabilität.

Unter Verwendung der Kraftmeßeinrichtung kann das Summensignal in einem in der Zeichnung nicht dargestellten Durchmesserregelkreis in einem elektrischen Komparator mit einem den gewünschten Durchmesserverlauf beschreibenden Sollwert verglichen und das Differenzsignal einem Regler zugeführt werden, der in bekannter Weise die Heizleistung oder die Transportgeschwindigkeit des Ziehgestänges in geeigneter Weise nachstellt.

Für den Fall, daß mit korrodierenden Stoffen in der Schmelzkammer gearbeitet werden muß, kann der magnetisierbare Kern mit einem korrosionsresistenten Überzug aus Quarzglas oder Graphit versehen sein.

Mittels der Stellschraube 28 kann der Stator 25 gegenüber der Unterlage 26 und dem Behälter 22 in radialer Richtung verschoben werden. Diese Justiereinrichtung ermöglicht sowohl die Ausrichtung von Tiegel- und Kristallachse als auch die Festlegung einer für den Zuchtprozeß erwünschten Exzentrizität zwischen den beiden Achsen.

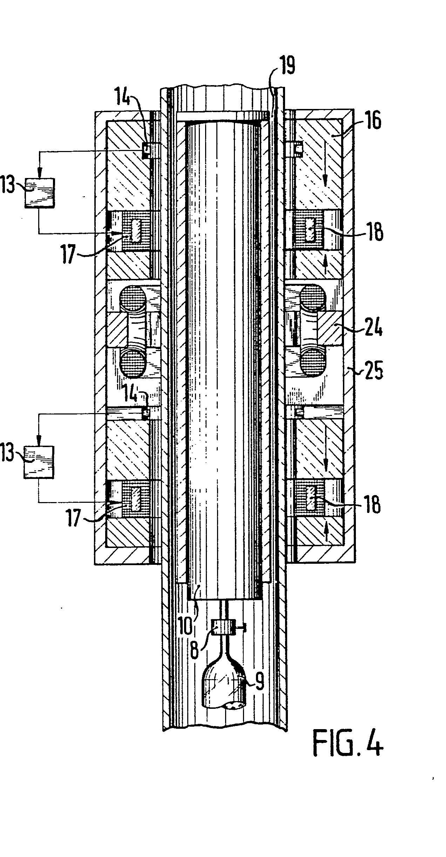

Bei der in Figur 4 gezeigten Ausführungsform der Vorrichtung sind—ebenso wie bei der in Figur 2 gezeigten Ausführungsform—die Elektromagnete der Radialstabilisierungseinrichtung mit einer im Ringspalt 19 im wesentlichen radial gerichteten Vormagnetisierung versehen. Hierzu sind die Ringspulen 17 der oberen Radialstabilisierungseinrichtung unterhalb des als Axialstabilisierungsmagnet wirkenden Permanentmagneten 16 angeordnet. Eine solche externe Vormagnetisierung könnte zwar auch elektromagnetisch erfolgen. Jedoch bietet die Verwendung des Permanentmagneten 16 besondere Vorteile. Denn dieser benötigt keine Leistung, arbeitet störungsfrei und erzeugt durch seine ringförmige Gestalt eine definierte stabile zentrische Achsenlage, bei der die auf den magnetisierbaren Kern einwirkenden stationären, radialen Magnetkräfte gleich Null sind.

Da die auf den magnetisierbaren Kern ausgeübten magnetischen Feldkräfte mit dem Produkt aus Vormagnetisierungs- und Regelfeldstärke anwachsen, können durch hohe permanente Vormagnetisierungsfeldstärke große dynamische Stabilisierungskräfte über große Ringspalte (<13 mm) bei kleiner elektromagnetisch erzeugter Regelfeldstärke erzeugt werden.

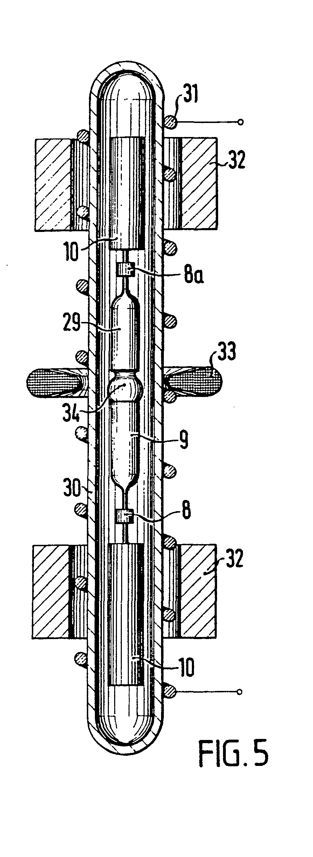

Figur 5 zeigt die Ausführungsform einer Vorrichtung zur Durchführung des Zonenschmelzverfahrens. Bei dieser Ausführungsform sind sowohl an der Befestigung 8 für den kristallinen Stab 9 als auch an der Befestigung 8a für den Vorratsstab 29 je ein magnetisierbarer Kern 10 angebracht. Die Zuchtkammer, in der sich die vorgenannten Vorrichtungsteile befinden, ist eine allseits geschlossene zylindrische Ampulle, deren Wandung 30 beispielsweise aus Quarzglas besteht. Diese Zuchtkammer wird durch eine den zylindrischen Teil umschließende Heizwicklung 31 temperiert.

Zur Aufhängung und radialen Verschiebung der magnetischen Kerne 10 sind Einrichtungen 32 vorgesehen, die im Detail den in den bisherigen Figuren dargestellten Ausführungsformen entsprechen können. Diese Einrichtungen sind durch in der Zeichnung nicht wiedergegebene Mittel gegen die Wärmestrahlung abgeschirmt und gekühlt.

Bei der Herstellung des Kristalls wird bei dem in Figur 5 dargestellten Beispiel der Vorratsstab 29 von oben nach unten durch die aus einer Widerstandsheizwicklung 33 bestehende Schmelzspule geführt. Alternativ kann auch die Schmelzspule selbst bewegt werden. Durch unterschiedliche Vorschubgeschwindigkeiten der beiden Stabteile 9 und 29 kann eine Streckung oder Stauchung in der Schmelzzone 34 bewirkt werden. Ein gewünschter seitlicher Versatz der Drehachse kann durch eine entsprechende mechanische Justierung der Lagerstatoren realisiert werden. Mittels Drehfeldstatoren ist es möglich, die magnetisierbaren Kerne 10 in Rotation zu versetzen.

**Patentansprüche**

1. Stab- und Tiegel-Halterung für Vorrichtungen zum tiegellosen Zonenschmelzen und zum Ziehen aus dem Tiegel mit einem, an der Halterung angebrachten magnetisierbaren Kern, der mittels eines Magneten (Axialstabilisierungsmagnet) aufgehängt ist, an dem eine Einrichtung zur axialen Verschiebung angreift, dadurch gekennzeichnet, daß wenigstens eine Radialstabilisierungseinrichtung für den magnetisierbaren Kern (10) vorgesehen ist, die aus den magnetisierbaren Kern berührungslos umschließenden Elektromagneten (11), einem elektronischen Regelgerät (13) und Positionsensoren (14) besteht, wobei die Elektromagnete vom elektronischen Regelgerät mit Signalen beaufschlagt werden, die von diesem als Funktion der Signale der Positionssensoren, welche auf die Abweichungen des magnetisierbaren Kerns von seiner Sollage ansprechen, erzeugt werden.

2. Halterung nach Anspruch 1, dadurch gekennzeichnet, daß eine den sich bildenden kristallinen Körper einschließende Kammer vorgesehen ist, deren Wandung in dem den magnetisierbaren Kern umfassenden Bereich aus nichtmagnetisierbarem Material besteht.

3. Halterung nach Anspruch 1 oder 2, dadurch gekennzeichnet, daß die Radialstabilisierungseinrichtung ringförmig ausgebildet ist und den magnetisierbaren Kern (10), zwischen diesem und sich einen Ringspalt bildend, umschließt.

4. Halterung nach Anspruch 3, dadurch gekennzeichnet, daß die Elektromagnete (11) der Radialstabilisierungseinrichtung mit einer im Ringspalt im wesentlichen radial gerichteten Vormagnetisierung versehen sind.

5. Halterung nach Anspruch 4, dadurch gekennzeichnet, daß zur Vormagnetisierung der Elektromagnete (11) Permanentmagnete (16) vorgesehen sind.

6. Halterung nach den Ansprüchen 4 bis 5, dadurch gekennzeichnet, daß der Axialstabilisierungsmagnet (16) unmittelbar oberhalb der Elektromagnete (11) der Stabilisierungseinrichtung so angeordnet ist, daß sein Magnetfeld den Ringspalt zwischen Elektromagneten und magnetisierbarem Kern (10) im wesentlichen radial durchsetzt.

7. Halterung nach einem der Ansprüche 3 bis 5, dadurch gekennzeichnet, daß die Einrichtung zur axialen Verschiebung ein elektromagnetischer Linearmotor (23, 10) ist, der aus einem hohlzylindrischen Stator und dem magnetisierbaren Kern (10) als Antriebselement besteht.

8. Halterung nach einem der Ansprüche 2 bis 7, dadurch gekennzeichnet, daß ein ringförmiger Drehfeldstator (24) mit einem zwischen sich und dem magnetisierbaren Kern (10) gebildeten Ringspalt vorgesehen ist.

9. Halterung nach einem der Ansprüche 2 bis 8, dadurch gekennzeichnet, daß eine Kraftmeßeinrichtung (27) vorgesehen und derart angeordnet ist, daß sie das Gewicht des kristallinen Körpers (9) aufnimmt.

**Revendications**

1. Dispositif de support d'une tige et d'un creuset pour des installations de fusion de zone sans creuset et pour le tirage à partir du creuset, comprenant un noyau magnétisable monté sur le dispositif de support et suspendu au moyen d'un aimant (aimant de stabilisation axiale) et sur lequel agit un dispositif de déplacement axial, caractérisé en ce qu'il est prévu pour le noyau (10) magnétisable au moins un dispositif de stabilisation radiale, constitué d'électro-aimants (11) entourant sans contact le noyau magnétisable, d'un appareil électronique de régulation (13) et de détecteurs ou capteurs de position (14), les électro-aimants recevant de l'appareil électronique de régulation des signaux qui sont formés par celui-ci en fonction des signaux des détecteurs de position, lesquels sont sensibles aux écarts du noyau magnétisable par rapport à sa position de consigne.

2. Dispositif de support suivant la revendication 1, caractérisé en ce qu'il est prévu une chambre enfermant le corps cristallin en formation et dont la paroi est, dans la partie entourant le noyau magnétisable, en matériau non magnétisable.

3. Dispositif de support suivant la revendication 1 ou 2, caractérisé en ce que le dispositif de stabilisation radiale est de forme annulaire et entoure le noyau magnétisable (10), avec formation entre eux d'une fente annulaire.

4. Dispositif de support suivant la revendication 3, caractérisé en ce que les électro-aimants (11) du dispositif de stabilisation radiale sont munis d'une prémagnétisation orientée sensiblement radialement dans la fente annulaire.

5. Dispositif de support suivant la revendication 4, caractérisé en ce qu'il est prévu, pour la prémagnétisation des électro-aimants, (11) des aimants permanents (16).

6. Dispositif de support suivant la revendication 4 ou 5 caractérisé en ce que l'aimant de stabilisation axiale (16) est disposé juste au-dessus des électro-aimants (11) du dispositif de stabilisation de façon que son champ magnétique s'étende sensiblement radialement dans la fente annulaire comprise entre les électro-aimants et le noyau magnétisable (10).

7. Dispositif de support suivant une des revendications 1 à 5, caractérisé en ce que le dispositif de déplacement axial est un moteur électromagnétique linéaire (23, 10), constitué d'un stator en forme de cylindre creux et du noyau magnétisable (10) comme élément d'entraînement.

8. Dispositif de support suivant l'une des revendications 1 à 7, caractérisé en ce qu'il est prévu un stator à champ tournant (24) de forme annulaire avec une fente annulaire formée entre lui et le noyau magnétisable (10).

9. Dispositif de support suivant l'une des revendications 2 à 8, caractérisé en ce qu'il est prévu un dispositif de mesure des forces (27) qui est disposé de façon à supporter le poids du corps cristallin (9).

**Claims**

1. Holder for ingot and crucible for apparatuses for non-crucible zone melting and for drawing from the crucible, having a magnetizable core which is attached to the holder and is suspended by means of a magnet (axial stabilizing magnet) on which a device for the axial displacement acts, characterized in that at least one radial stabilizing device for the magnetizable core (10) is provided, which radial stabilizing device consists of electromagnets (11), surrounding the magnetizable core without contact, an electronic control unit (13) and position sensors (14), the electromagnets being acted upon by signals from the electronic control unit which are produced by the latter as a function of the signals from the position sensors, which respond to deviations of the magnetizable core from its desired position.

2. Holder according to Claim 1, characterized in that a chamber is provided which encloses the developing crystalline article and whose wall, in the area surrounding the magnetizable core, is made of non-magnetizable material.

3. Holder according to Claim 1 or 2, characterized in that the radial stabilizing device is of annular design and, forming an annular gap between itself and the magnetizable core (10), surrounds the latter.

4. Holder according to Claim 3, characterized in that the electromagnets (11) of the radial stabilizing device are provided with a magnetic bias essentially directed radially in the annular gap.

5. Holder according to Claim 4, characterized in that permanent magnets (16) are provided to magnetically bias the electromagnets (11).

6. Holder according to Claims 4 to 5, characterized in that the axial stabilizing magnet (16) is arranged directly above the electromagnets (11) of the stabilizing device in such a way that its magnetic field essentially passes radially through the annular gap between electromagnets and magnetizable core (10).

7. Holder according to one of Claims 3 to 5, characterized in that the device for the axial displacement is an electromagnetic linear motor (23, 10) which consists of a hollow-cylindrical stator and the magnetizable core (10) as drive element.

8. Holder according to one of Claims 2 to 7, characterized in that an annular rotary-field stator (24) having an annular gap between itself and the magnetizable core (10) is provided.

9. Holder according to one of Claims 2 to 8, characterized in that a force-measuring device (27) is provided and arranged in such a way that it records the weight of the crystalline article (9).

10b
7
6
5
3
11
12
13
14
10a
11
12
13
4
14
10
8
9
2
15
1

FIG. 1

20
8
9
1
15
10
19
14a
16
13a
17a
18a
21
17b
18b
13b
14b

FIG. 2

22
19
23
10
14
13
12
11
25
24
11
12
13
14
28
27
26
8
9
15
1

FIG. 3

19
14
16
13
18
17
24
25
14
13
18
17
10
8
9

FIG. 4

31
32
10
8a
29
33
34
9
30
8
32
10
FIG. 5